# EUROPEAN PATENT SPECIFICATION

(11) **EP 4 033 872 B1**
(45) Date of publication and mention of the grant of the patent: **02.07.2025**
(21) Application number: 19946092.4
(22) Date of filing: 18.09.2019
(51) Int. Cl.: H05K 13/08

(54) **COMPONENT MOUNTING MACHINE**
KOMPONENTENMONTAGEMASCHINE
MACHINE DE MONTAGE DE COMPOSANT

(43) Date of publication of application: 27.07.2022
(73) Proprietor: Fuji Corporation, Chiryu-shi, Aichi 472-8686 (JP)
(72) Inventor: KAGIMOTO Yusaku, Chiryu-shi, Aichi 472-8686 (JP)
(74) Representative: Grünecker Patent- und Rechtsanwälte PartG mbB
(86) International application number: PCT/JP2019/036518
(87) International publication number: WO 2021/053747

(56) References cited:
- JP-A- H03 208 400
- JP-A- H1 050 093
- JP-B2- 2 816 485
- US-A- 5 452 080
- US-A- 5 956 134
- US-A- 6 118 538
- US-A- 6 133 579

## Description

### Technical Field

The present specification discloses a component mounting machine.

### Background Art

Conventionally, a component mounting machine for detecting the coplanarity of a lead in an electronic component including a main body and multiple leads protruding laterally from a side surface of the main body (degree to which tip end portions of multiple leads are located on the same plane) has been proposed (refer to, for example, Patent Literature 1). The component mounting machine is provided with a camera for coplanarity detection whose position is fixed in a state of being inclined toward the electronic component held by a holding device and in a direction toward the bottom surface from an upper surface as the optical axis approaches the electronic component with respect to the bottom surface of the component main body, and a planar light source provided at a position corresponding to the camera. The component mounting machine stops the holding device while the electronic component is taken out and moved to a printed wiring board, and images the electronic component by the camera. The component mounting machine rotates the electronic component to image all the leads on the four sides, performs image processing on the captured image data, and detects the coplanarity.

US 5452080 A relates to coplanarity detection of leads on components. Each component is imaged from below or above wherein mirrors are located besides the component with an angle of 45° to the imaging direction such that each image also includes images of the sides of the component. From the images of the sides of the component, the length of the longest of the leads (in side view) is determined.

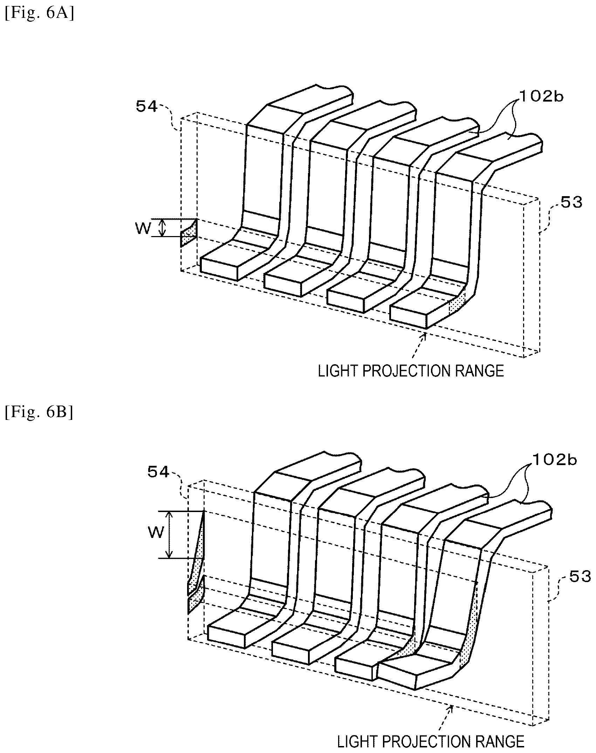

US 6133579 A relates to coplanarity detection of leads on components. A point-like light source illuminates a row of leads on the component and the size of the shadow from the leads is detected behind the components. As the light source is point-like, the light and the shadow thrown from the first lead in the row is divergent. Therefore the height of the component is varied such that the tips of the leads behind the first lead can also be detected (c.f. figure 6).

### Patent Literature

Patent Literature 1: JP-A-2002-176300

### Summary of the Invention

### Technical Problem

However, in the component mounting machine described above, a dedicated camera is required to detect the state (coplanarity) of the lead, which leads to an increase in the size and cost of the device.

It is a main object of the present disclosure to provide a component mounting machine capable of appropriately determining the states of multiple leads protruding laterally from a main body of a component with a simple configuration.

The invention is defined by the features of the independent claims. Any reference to inventions or embodiments not falling within the scope of the independent claims are to be interpreted as examples useful for understanding the invention.

### Solution to Problem

The present disclosure adopts the following means to achieve the main object described above.

The component mounting machine of the present disclosure holds a component and mounts the component on a board, and it is a gist to include a head having a holding member configured to hold the component from an upper surface side, a moving device configured to move the head, an imaging device configured to image the component held by the holding member from a direction perpendicular to a bottom surface, and a control device configured to control the head and the moving device so that the component held by the holding member is mounted on the board after performing image processing for processing a captured image of the component imaged by the imaging device, in which when mounting a component having a main body and multiple leads protruding laterally from a side surface of the main body, the control device measures each of lengths of images of the multiple leads extracted from the captured image, and performs a first determination of abnormality in which it is determined as abnormal in a case where at least one of the measured lengths of the images of the leads is not within an allowable range.

The control device of the component mounting machine according to the present disclosure controls the head and the moving device so that the component held by the holding member is mounted on the board after performing image processing for processing a captured image of the component imaged by the imaging device. In addition, when mounting a component having a main body and multiple leads protruding laterally from a side surface of the main body, the control device measures each of lengths of images of the multiple leads extracted from the captured image, and performs a first determination of abnormality that it is determined as abnormal in a case where at least one of the lengths of the images of the leads is not within an allowable range. In the component having multiple leads protruding laterally from the side surface of the main body, when lead floating occurs in any of multiple leads, the length of the image of the lead extracted from the captured image in a case where the component is imaged from the direction perpendicular to the bottom surface of the main body is longer than that in which the lead floating does not occur. Accordingly, when it is determined that there is an abnormality in a case where at least one of the lengths of the images of the leads is not within the allowable range, the state of the leads can be appropriately determined. In addition, since the imaging device is also used as a device used for image processing performed before mounting the component, the component mounting machine does not need to include a dedicated imaging device for determining the state of the lead. As a result, with a simple configuration, it is possible to provide the component mounting machine capable of appropriately determining the states of multiple leads protruding laterally from the main body of the component.

### Brief Description of Drawings

Fig. 1 is a configuration view schematically illustrating a configuration of component mounting machine 10 of the present embodiment.
Fig. 2 is a top view of component mounting machine 10.
Fig. 3 is a block diagram illustrating an electrical connection relationship between control device 60 of component mounting machine 10 and management device 80.
Fig. 4 is a configuration view schematically illustrating a configuration of optical sensor 50.
Fig. 5A is an explanatory view illustrating a side view of multiple leads 102a protruding from one side of main body 101a in component 100a having a low height of the lead and a light projection range of light projector 53.
Fig. 5B is an explanatory view illustrating a side view of multiple leads 102b protruding from one side of main body 101b in component 100b having a high height of the lead and a light projection range of light projector 53.
Fig. 6A is an explanatory view illustrating a state where light from light projector 53 is shielded by multiple leads 102b in a case where any of multiple leads 102b of component 100b is normal.
Fig. 6B is an explanatory view illustrating a state where light from light projector 53 is shielded by multiple leads 102b in a case where there is an abnormality in any of multiple leads 102b of component 100b.
Fig. 7 is a flowchart illustrating an example of component mounting processing executed by CPU 61 of control device 60.
Fig. 8 is an explanatory view illustrating a state where a lead floating or the like is determined from a captured image imaged by mark camera 25.

### Description of Embodiments

Next, embodiments of the present invention will be described using examples.

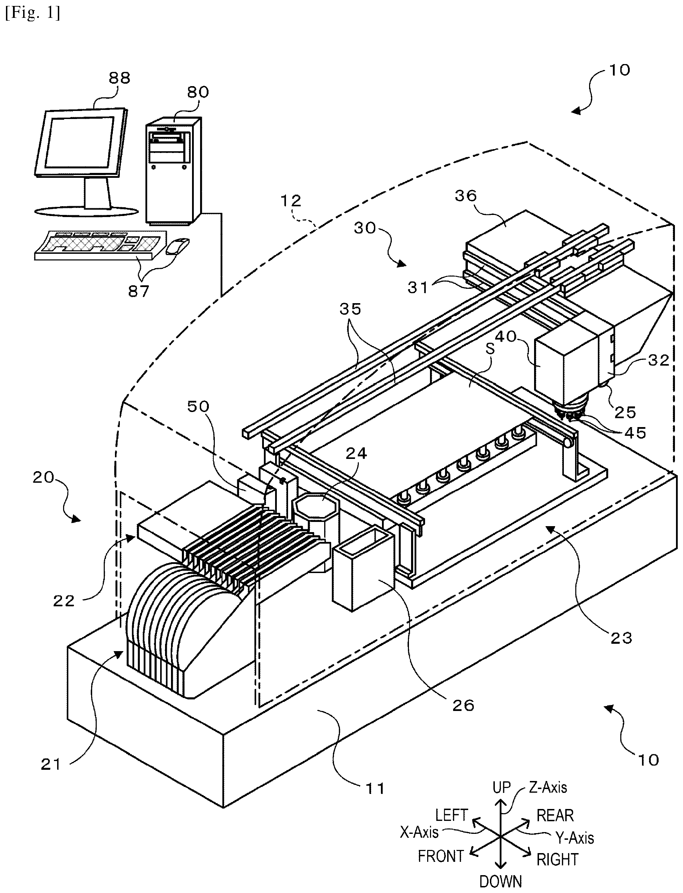

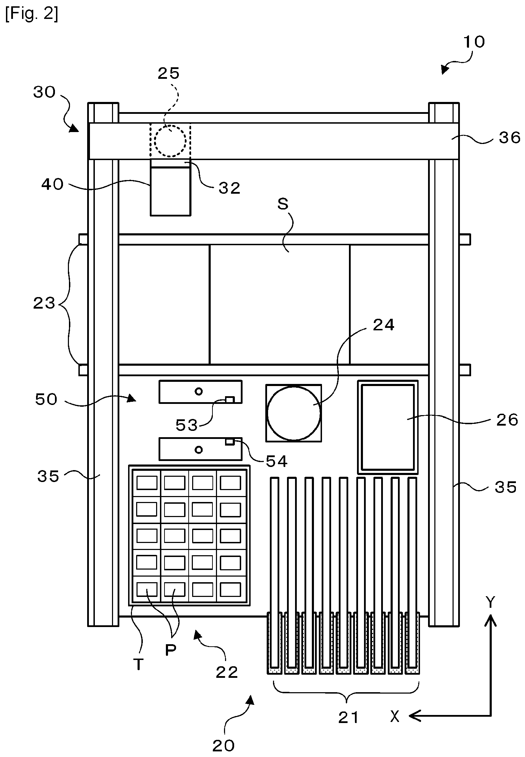

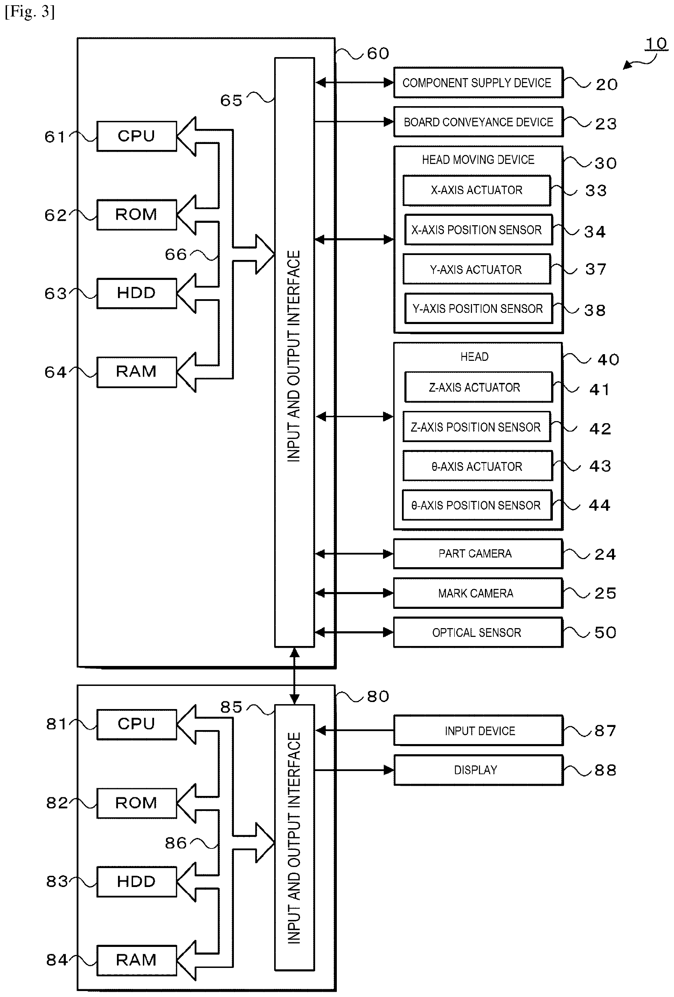

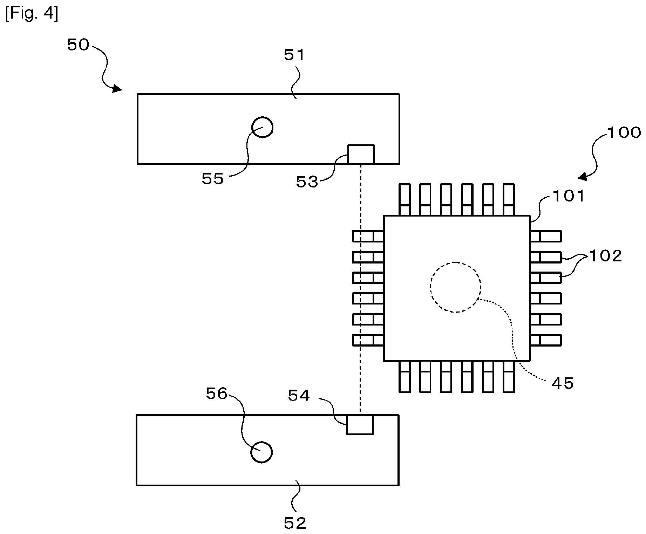

Fig. 1 is a configuration view schematically illustrating a configuration of component mounting machine 10 of the present embodiment. Fig. 2 is a top view of component mounting machine 10. Fig. 3 is a block diagram illustrating an electrical connection relationship between control device 60 of component mounting machine 10 and management device 80. Fig. 4 is a configuration view schematically illustrating a configuration of optical sensor 50. In Fig. 1, the left-right direction is the X-axis direction, the front-rear (depth) direction is the Y-axis direction, and the up-down direction is the Z-axis direction.

As illustrated in Fig. 1, component mounting machine 10 is provided with component supply device 20, board conveyance device 23, head moving device 30, head 40, optical sensor 50, and control device 60 (refer to Fig. 3). In addition to these, component mounting machine 10 also is provided with part camera 24, mark camera 25, discard box 26, and the like. Multiple component mounting machines 10 are arranged side by side in the board conveyance direction (X-axis direction) to form a production line. The production line is managed by management device 80.

Component supply device 20 is provided with tape feeder 21 and tray feeder 22 provided at a front end portion of base plate 11 of component mounting machine 10. Tape feeder 21 is disposed so as to be arranged side by side in the left-right direction (X-axis direction), and supplies the component by drawing a tape in which the components are accommodated in each of multiple recessed portions formed at predetermined intervals in the longitudinal direction from a reel in the front-rear direction (Y-axis direction). Tray feeder 22 supplies the component by feeding a tray in which the components are accommodated in each of multiple recessed portions formed in a lattice shape in the front-rear direction (Y-axis direction). Tray feeder 22 is used, for example, when supplying relatively large electronic components (IC components) such as a small outline package (SOP) and a quad flat package (QFP).

Board conveyance device 23 is provided with a pair of conveyor rails disposed on base plate 11 at intervals in the front-rear direction (Y-axis direction). Board conveyance device 23 conveys board S from the left to the right in Fig. 1 (board conveyance direction) by driving a pair of conveyor rails.

As illustrated in Fig. 1, head moving device 30 is provided with a pair of X-axis guide rails 31, X-axis slider 32, X-axis actuator 33 (refer to Fig. 3), a pair of Y-axis guide rails 35, Y-axis slider 36, and Y-axis actuator 37 (refer to Fig. 3). The pair of Y-axis guide rails 35 are disposed on an upper stage of housing 12 so as to extend parallel to each other in the Y-axis direction. Y-axis slider 36 is spanned by the pair of Y-axis guide rails 35. Y-axis actuator 37 moves Y-axis slider 36 in the Y-axis direction along Y-axis guide rail 35. The pair of X-axis guide rails 31 are disposed on a front surface of Y-axis slider 36 so as to extend parallel to each other in the X-axis direction. X-axis slider 32 is spanned by the pair of X-axis guide rails 31. X-axis actuator 33 moves X-axis slider 32 in the X-axis direction along X-axis guide rail 31. Head 40 is attached to X-axis slider 32. Head moving device 30 moves head 40 in the X-axis direction and the Y-axis direction by moving X-axis slider 32 and Y-axis slider 36.

As illustrated in Fig. 3, head 40 is provided with Z-axis actuator 41 and θ-axis actuator 43. Z-axis actuator 41 moves suction nozzle 45 in the up-down direction (Z-axis direction). In addition, θ-axis actuator 43 rotates suction nozzle 45 around the Z-axis. Although not illustrated, the suction port of suction nozzle 45 selectively communicates with the negative pressure source, the positive pressure source, and the air introduction port by a solenoid valve. Head 40 can pick up the component by the negative pressure acting on the suction port by causing the suction port of suction nozzle 45 to abut on the upper surface of the component in a state where the suction port of suction nozzle 45 is in communication with the negative pressure source. In addition, by causing the suction port of suction nozzle 45 to communicate with the positive pressure source, head 40 can release the pickup of the component by positive pressure acting on the suction port.

Part camera 24 is disposed between component supply device 20 and board conveyance device 23 of base plate 11. When a component picked up by suction nozzle 45 passes above part camera 24, part camera 24 images the bottom surface of the component from a direction perpendicular to the bottom surface of the component. The captured image imaged by part camera 24 is output to control device 60. Control device 60 performs an image processing for recognizing a component on the captured image of part camera 24, which enables device 60 to perform; a determination whether the component is picked up by suction nozzle 45, a determination whether the picked up component is normal, a determination whether the amount of each of the positional deviations (Δx, Δy, Δθ) in the X-axis direction, the Y-axis direction, and the θ-axis direction of the picked up component are within an allowable range, and the like.

Mark camera 25 is attached to X-axis slider 32. Mark camera 25 images a mark affixed to the surface of board S from a direction perpendicular to the surface. The captured image imaged by mark camera 25 is output to control device 60. Control device 60 confirms the position of board S by performing image processing for recognizing the mark on the captured image of mark camera 25.

Discard box 26 is intended to discard a component that is a target of the abnormality when an abnormality occurs in the picked up component.

Optical sensor 50 is used to determine whether an abnormality occurs in any of leads 102 in a case where component 100 having rectangular main body 101 and multiple leads 102 protruding in a gull-wing shape (L-shape) from a side surface of main body 101 is to be mounted, such as SOP or QFP. The abnormality of lead 102 may include lead floating in which lead 102 is bent toward the outside of main body 101, and lead breakage in which lead 102 is bent toward the inside of main body 101. Any of these abnormalities cannot cause all of leads 102 protruding from the side surface of main body 101 to uniformly contact board S (solder), which causes a defective product to be generated.

As illustrated in Fig. 2, optical sensor 50 is disposed between component supply device 20 and board conveyance device 23 of base plate 11 and at a position adjacent to part camera 24. As illustrated in Fig. 4, optical sensor 50 is provided with light projector 53 provided on support base 51, and light receiver 54 provided on support base 52 so as to face light projector 53 with a predetermined space therebetween. Alignment marks 55 and 56 for aligning the position of component 100 with the detection position of optical sensor 50 are attached to the upper surface of each support base 51 and 52. Marks 55 and 56 may be omitted.

In a case of determining the state of lead 102 using optical sensor 50, control device 60 aligns component 100 so that the optical axis (refer to dashed lines in Fig. 4) directed from light projector 53 to light receiver 54 is parallel to the arrangement direction of multiple leads 102 protruding from one side surface of main body 101 and passes through tip end portions of multiple leads 102, as illustrated in Fig. 4, in a state where component 100 is picked up by suction nozzle 45. The alignment of component 100 is performed by driving and controlling X-axis actuator 33 and Y-axis actuator 37 of head moving device 30, and driving and controlling Z-axis actuator 41 and θ-axis actuator 43 of head 40 to move suction nozzle 45 that picks up component 100 in the XY-axis direction and rotate suction nozzle 45 in the θ-axis direction. Subsequently, control device 60 drives and controls light projector 53 so that light is projected from light projector 53 toward light receiver 54. As a result, a part of the light from light projector 53 is shielded by the tip end portions of multiple leads 102, and the remaining light is received by light receiver 54. Here, in a case where the lead floating or the like occurs in a part of multiple leads 102 protruding from one side surface of main body 101 so that a normal lead and an abnormal lead are mixed, apparent thickness W in the side view of multiple leads 102 is increased as compared with a case where all of multiple leads 102 are normal. The greater the degree of lead floating and the like, the thicker thickness W. As thickness W increases, the shielding rate of the light from light projector 53 by multiple leads 102 increases, so that the amount of light received by light receiver 54 decreases. Accordingly, control device 60 can determine apparent thickness W of multiple leads 102 in the side view based on the amount of light received by light receiver 54, and can determine the states of multiple leads 102 based on thickness W. That is, control device 60 determines thickness W based on a light-receiving signal from light receiver 54, determines that any of multiple leads 102 protruding from one side surface of main body 101 is normal when thickness W is within the allowable range, and determines that at least one of multiple leads 102 is abnormal when thickness W is not within the allowable range. In a case where component 100 is configured as QFP in which multiple leads protrude from each of the four side surfaces of the main body, control device 60 determines the states of all the leads protruding from the four side surfaces by irradiating light from light projector 53 to the tip end portions of multiple leads protruding from the corresponding side surfaces at each of rotational positions while rotating component 100 by 90°. In addition, in a case where component 100 is configured as SOP or SSOP in which multiple leads protrude from each of two facing side surfaces of the main body, control device 60 determines the states of all the leads protruding from the two side surfaces by irradiating light from light projector 53 to the tip end portions of multiple leads protruding from the corresponding side surfaces at each of rotational positions while rotating component 100 by 180°.

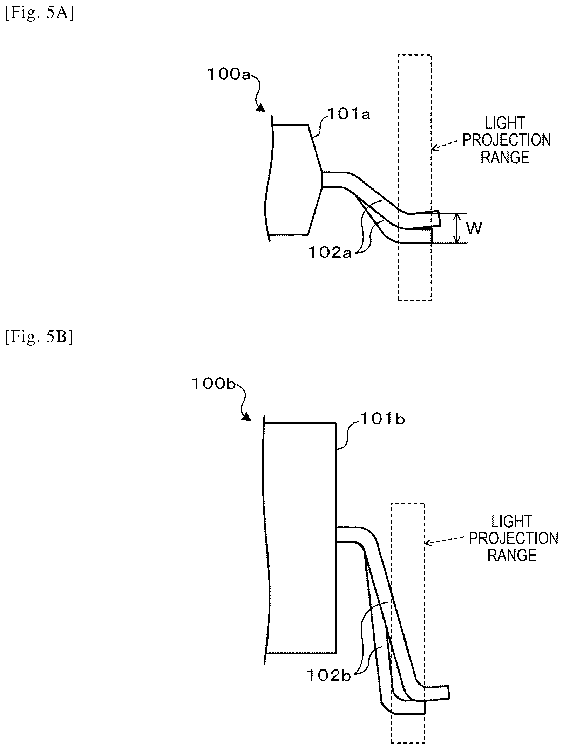

Here, as illustrated in Fig. 5A, optical sensor 50 effectively functions in a case where it is determined whether an abnormality occurs in a part of multiple leads 102a protruding from one side surface of main body 101a in component 100a in which main body 101a is relatively thin and the height of the lead is low. However, as illustrated in Fig. 5B, optical sensor 50 may not function effectively in a case where it is determined whether a similar abnormality occurs in component 100b in which main body 101b is relatively thick and the height of the lead is high (length of a rising edge portion of the lead is long). That is, in component 100b having a high height of the lead, even when lead 102b slightly floats or breaks, since the tip end portion of lead 102b deviates from the light projection range of light projector 53, as illustrated in Figs. 5B, 6A, and 6B, it is difficult for control device 60 to determine apparent thickness W of multiple leads 102b in the side view based on the amount of light received from light receiver 54.

As illustrated in Fig. 3, control device 60 is configured as a microprocessor centered on CPU 61, and is provided with ROM 62, HDD 63, RAM 64, and input and output interface 65, in addition to CPU 61. These are electrically connected to one another via bus 66. Various detection signals are input to control device 60 via input and output interface 65. Examples of the various detection signals input to control device 60 include a position signal from X-axis position sensor 34 that senses the position of X-axis slider 32, a position signal from Y-axis position sensor 38 that senses the position of Y-axis slider 36, a position signal from Z-axis position sensor 42 that senses the position of suction nozzle 45 in the Z-axis direction, and a position signal from θ-axis position sensor 44 that sense the position of suction nozzle 45 in the θ-axis direction. In addition, the various signals input to control device 60 include an image signal from part camera 24, an image signal from mark camera 25, and the light-receiving signal from light receiver 54 of optical sensor 50. On the other hand, various control signals are output from control device 60 via input and output interface 65. Examples of the various control signals output from control device 60 include a control signal to component supply device 20 and a control signal to board conveyance device 23. In addition, the various control signals output from control device 60 include a drive signal to X-axis actuator 33, a drive signal to Y-axis actuator 37, a drive signal to Z-axis actuator 41, and a drive signal to θ-axis actuator 43. Furthermore, the various control signals output from control device 60 include a control signal to part camera 24, a control signal to mark camera 25, and a drive signal to light projector 53 of optical sensor 50. In addition, control device 60 is connected to management device 80 so as to be capable of bidirectional communication, and exchanges data and control signals with each other.

For example, management device 80 is a general-purpose computer, and is provided with CPU 81, ROM 82, HDD 83, RAM 84, input and output interface 85, and the like, as illustrated in Fig. 3. These are electrically connected to one another via bus 86. An input signal from input device 87 such as a mouse and a keyboard is input to management device 80 via input and output interface 85. In addition, an image signal to display 88 is output from management device 80 via input and output interface 85. HDD 83 stores a production job of board S. Here, the production job of board S includes a production schedule such as which components are mounted on board S in which order in each component mounting machine 10, and how many sheets of board S on which the components are mounted in this manner are prepared. Management device 80 generates a production job based on various types of data input by an operator via input device 87, transmits the generated production job to each component mounting machine 10, and thus instructs each component mounting machine 10 to start production.

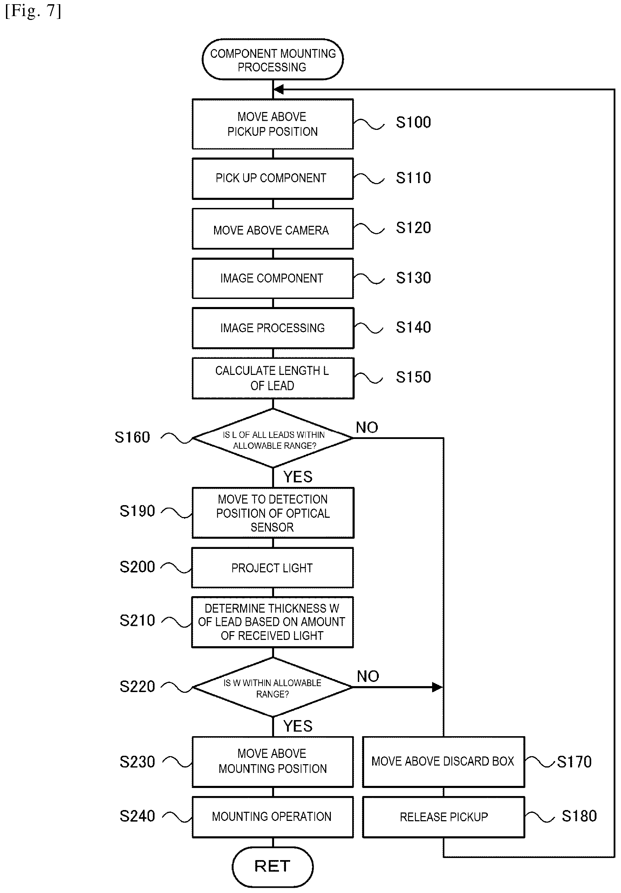

Next, an operation of component mounting machine 10 of the present embodiment configured as described above will be described. In particular, an operation when component 100 having lead 102 protruding laterally from main body 101 is mounted will be described. Fig. 7 is a flowchart illustrating an example of component mounting processing executed by CPU 61 of control device 60. This processing is executed when the start of production is instructed by the operator. Control device 60 receives the production job transmitted from management device 80, and executes the component mounting processing based on the received production job.

When the component mounting processing is executed, CPU 61 of control device 60 first drives and controls head moving device 30 so that suction nozzle 45 moves above the component supply position to which component 100 is supplied from component supply device 20 (tray feeder 22) (S100), and performs the pickup operation to cause suction nozzle 45 to pick up component 100 (S110). Here, specifically, the pickup operation is performed by driving and controlling Z-axis actuator 41 so that suction nozzle 45 descends until the tip end (suction port) of suction nozzle 45 abuts on the upper surface of component 100, and driving and controlling the solenoid valve so that the negative pressure acts on the suction port of suction nozzle 45. Subsequently, CPU 61 drives and controls head moving device 30 so that component 100 picked up by suction nozzle 45 moves above part camera 24 (S120), and images component 100 with part camera 24 (S130).

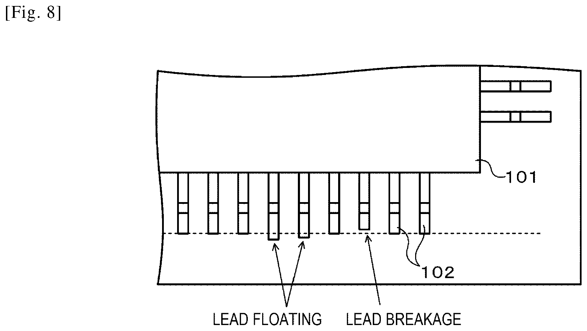

When component 100 is imaged, CPU 61 performs image processing for recognizing component 100 in the obtained captured image (S140). CPU 61 calculates the length (length L of lead) of each lead 102 from the image of each lead 102 in recognized component 100 (S150), and determines whether length L of the lead of all of leads 102 of component 100 is within the allowable range (S160). Here, part camera 24 images component 100 from a direction perpendicular to the bottom surface of component 100. Accordingly, length L of the lead is the length of the image of lead 102 as viewed from the bottom surface side of component 100. As described above, lead 102 protrudes in a gull-wing shape (L-shape) from the side surface of main body 101. Therefore, as illustrated in Fig. 8, the image of the lead where the lead floating bending toward the outside of main body 101 occurs is longer than usual. On the other hand, the image of the lead where the lead breakage bending inside main body 101 occurs is shorter than usual. Accordingly, when it is determined that the length of the image of lead 102 in the image imaged by part camera 24, it is possible to determine whether the lead floating or the lead breakage occurs. The length of such an image of the lead is remarkably expressed with respect to the occurrence of lead floating or lead breakage, as the height of the lead of the component is higher. Accordingly, the determination of the state of lead 102 using part camera 24 effectively functions for component 100b in which main body 101b is thick and the height of the lead is high, whereas the determination does not effectively function for component 100a in which main body 101a is thin and the height of the lead is low. When it is determined that length L of the lead of at least one of leads 102 is not within the allowable range, CPU 61 determines that there is an abnormality in lead 102 of component 100, and drives and controls head moving device 30 so that component 100 picked up by suction nozzle 45 moves above discard box 26 (S170). CPU 61 discards component 100 to discard box 26 by acting positive pressure on the suction port of suction nozzle 45 (S180), and returns to Step S100 in order to pick up new component 100.

When it is determined in Step S160 that length L of the lead of any of leads 102 is within the allowable range, CPU 61 further drives and controls head moving device 30 so that component 100 picked up by suction nozzle 45 moves to the detection position of optical sensor 50 in order to determine the state of lead 102 using optical sensor 50 (S190). This processing is performed as follows. That is, CPU 61 confirms a pickup position of component 100 by the image processing performed on the captured image of component 100 by part camera 24 in Step S140. Subsequently, CPU 61 drives and controls head moving device 30 so that mark camera 25 moves above marks 55 and 56 attached to support bases 51 and 52, so that marks 55 and 56 are imaged by mark camera 25. Next, CPU 61 confirms the detection position of optical sensor 50 (position of the optical axis of light projector 53) based on the obtained captured image. CPU 61 drives and controls head moving device 30 so that the tip end portions of multiple leads 102 protruding from one side surface of component 100 moves to the detection position based on the pickup position of component 100, the detection position of optical sensor 50, and the size of component 100 input in advance.

When component 100 is moved to the detection position of optical sensor 50, CPU 61 sequentially projects light from light projector 53 to the tip end portions of multiple leads 102 protruding from each of the side surfaces of main body 101 of component 100 as described above (S200), and determines apparent thickness W in the side view of multiple leads 102 based on the amount of light received by light receiver 54 (S210). CPU 61 determines whether any of apparent thicknesses W of multiple leads 102 protruding from each of the side surfaces are within the allowable range (S220). As described above, the determination of the state of lead 102 using optical sensor 50 effectively functions for component 100a in which main body 101a is thin and the height of the lead is low, whereas the determination does not effectively function for component 100b in which main body 101b is thick and the height of the lead is high. Accordingly, by using both the determination using part camera 24 and the determination using optical sensor 50, the state of lead 102 can be more accurately determined regardless of the height of the lead. As a result, the state of lead 102 can be more accurately determined without requiring a dedicated camera. When it is determined that at least one of thicknesses W is not within the allowable range, CPU 61 drives and controls head moving device 30 so that component 100 picked up by suction nozzle 45 moves above discard box 26 (S170). CPU 61 discards component 100 to discard box 26 (S180), and returns to Step S100 in order to pick up new component 100.

When it is determined in Step S220 that any of thickness W is within the allowable range, CPU 61 drives and controls head moving device 30 so that component 100 picked up by suction nozzle 45 moves above the mounting position of board S (S230), performs the mounting operation for mounting component 100 on board S (S240), and terminates the present processing. Here, specifically, the mounting operation is performed by driving and controlling Z-axis actuator 41 so that suction nozzle 45 descends until component 100 picked up by suction nozzle 45 abuts on board S, and driving and controlling the solenoid valve so that the positive pressure acts on the suction port of suction nozzle 45.

Here, the correspondence relationship between the main elements of the embodiments and the main elements of the invention described in the disclosure section of the invention will be described. That is, suction nozzle 45 corresponds to a holding member, head 40 corresponds to a head, head moving device 30 corresponds to a moving device, part camera 24 corresponds to an imaging device, and control device 60 corresponds to a control device. In addition, light projector 53 corresponds to a light projecting section, light receiver 54 corresponds to a light receiving section, and optical sensor 50 corresponds to an optical sensor.

It goes without saying that the present invention is not limited to the above-described embodiments, and can be implemented in various aspects without departing from the technical scope of the appended claims.

For example, in the above embodiment, when determining the state of lead 102 protruding from the side surface of main body 101 of component 100, CPU 61 first executes the determination using part camera 24, and in a case where there is no abnormality in the determination, executes the determination using optical sensor 50. However, CPU 61 may first execute the determination using optical sensor 50, and may execute the determination using part camera 24 in a case where there is no abnormality in the determination.

In addition, in the above embodiment, when determining the state of lead 102 protruding from the side surface of main body 101 of component 100, CPU 61 uses both the determination using part camera 24 and the determination using optical sensor 50. However, CPU 61 may input component data including the height of the lead of the component in advance, and select to execute one of the determinations using part camera 24 and the determination using optical sensor 50, which is suitable for the component to be determined, based on the input component data (height of the lead). In a case where only a component having a high height of the lead is mounted on component mounting machine 10, optical sensor 50 may be omitted.

As described above, a component mounting machine of the present disclosure holds a component and mounts the component on a board, and it is a gist to include a head having a holding member configured to hold the component from an upper surface side, a moving device configured to move the head, an imaging device configured to image the component held by the holding member from a direction perpendicular to a bottom surface, and a control device configured to control the head and the moving device so that the component held by the holding member is mounted on the board after performing image processing for processing a captured image of the component imaged by the imaging device, in which when mounting a component having a main body and multiple leads protruding laterally from a side surface of the main body, the control device measures each of lengths of images of the multiple leads extracted from the captured image, and performs a first determination of abnormality in which it is determined as abnormal in a case where at least one of the measured lengths of the images of the leads is not within an allowable range.

The control device of the component mounting machine according to the present disclosure controls the head and the moving device so that the component held by the holding member is mounted on the board after performing image processing for processing a captured image of the component imaged by the imaging device. In addition, when mounting a component having a main body and multiple leads protruding laterally from a side surface of the main body, the control device measures each of lengths of images of the multiple leads extracted from the captured image, and performs a first determination of abnormality that it is determined as abnormal in a case where at least one of the lengths of the images of the leads is not within an allowable range. In the component having multiple leads protruding laterally from the side surface of the main body, when lead floating occurs in any of multiple leads, the length of the image of the lead extracted from the captured image in a case where the component is imaged from the direction perpendicular to the bottom surface of the main body is longer than that in which the lead floating does not occur. Accordingly, when it is determined that there is an abnormality in a case where at least one of the lengths of the images of the leads is not within the allowable range, the state of the leads can be appropriately determined. In addition, since the imaging device is also used as a device used for image processing performed before mounting the component, the component mounting machine does not need to include a dedicated imaging device for determining the state of the lead. As a result, with a simple configuration, it is possible to provide the component mounting machine capable of appropriately determining the states of multiple leads protruding laterally from the main body of the component.

In such a component mounting machine of the present disclosure, the machine may further include an optical sensor having a light projecting section and a light receiving section disposed so as to face each other with a predetermined space therebetween, in which the control device may control the moving device so that the component held by the holding member moves to a detection position where light is projected from the light projecting section toward tip end portions of the multiple leads with an optical axis parallel to an arrangement direction of the multiple leads, measure a thickness of the multiple leads in a side view based on a state where the light is received by the light receiving section, and perform a second determination of abnormality in which it is determined as abnormal in a case where the measured thickness is not within an allowable range. By using both the determination using the imaging device and the determination using the optical sensor, it is possible to appropriately determine the state of the lead even for multiple types of components having different height of the leads. In this case, the control device may perform the second determination of abnormality in a case where it is not determined as abnormal in the first determination of abnormality. Furthermore, in this case, when performing the second determination of abnormality, the control device may acquire a holding position of the component by the holding member by the image processing, input the size of the component, and control the moving device so that the component held by the holding member moves to the detection position based on the obtained holding position and the input size of the component. As a result, it is possible to more accurately move the component to the detection position of the optical sensor based on the holding position of the component obtained by the image processing.

It goes without saying that the present disclosure is not limited to the above-described embodiments, and can be implemented in various aspects without departing from the technical scope of the appended claims.

### Industrial Applicability

The present invention can be applied in the manufacturing industry for the component mounting machine or the like.

### Reference Signs List

10 component mounting machine, 11 base plate, 12 housing, 20 component supply device, 21 tape feeder, 22 tray feeder, 23 board conveyance device, 24 part camera, 25 mark camera, 26 discard box, 30 head moving device, 31 X-axis guide rail, 32 X-axis slider, 33 X-axis actuator, 35 Y-axis guide rail, 36 Y-axis slider, 37 Y-axis actuator, 40 head, 41 Z-axis actuator, 42 Z-axis position sensor, 43 θ-axis actuator, 44 θ-axis position sensor, 45 suction nozzle, 50 optical sensor, 51, 52 support base, 53 light projector, 54 light receiver, 55, 56 mark, 60 control device, 61 CPU, 62 ROM, 63 HDD, 64 RAM, 65 input and output interface, 66 bus, 80 management device, 81 CPU, 82 ROM, 83 HDD, 84 RAM, 85 input and output interface, 86 bus, 87 input device, 88 display, S board

## Claims

1. A component mounting machine (10) that is configured to hold a component (100) and mount the component (100) on a board, the machine comprising:
a head (40) having a holding member configured to hold the component (100) from an upper surface side;
a moving device configured to move the head (40);
an imaging device configured to image the component (100) held by the holding member from a direction perpendicular to a bottom surface; and
a control device (60) configured to control the head (40) and the moving device so that the component (100) held by the holding member is mounted on the board after performing image processing for processing a captured image of the component (100) imaged by the imaging device, wherein
when mounting a component (100) having a main body (101) and multiple leads (102) protruding laterally from a side surface of the main body (101), the control device (60) measures each of lengths of images of the
multiple leads (102) extracted from the captured image, and performs a first determination of abnormality in which it is determined as abnormal in a case where at least one of the measured lengths of the images of the leads (102) is not within an allowable range,
wherein the component mounting machine (10) further comprises:
an optical sensor (50) having a light projecting section (53) and a light receiving section (54) disposed so as to face each other with a predetermined space there between, wherein
the control device (60) is configured to control the moving device so that the component (100) held by the holding member moves to a detection position where light is projected from the light projecting section (53) toward tip end portions of the multiple leads (102) with an optical axis parallel to an arrangement direction of the multiple leads (102), measures a thickness of the multiple leads (102) in a side view based on a state where the light is received by the light receiving section (54), and performs a second determination of abnormality in which it is determined as abnormal in a case where the measured thickness is not within an allowable range,, wherein
the control device (60) is configured to perform the second determination of abnormality in a case where it is not determined as abnormal in the first determination of abnormality.

2. The component mounting machine (10) according to claim 1, wherein
when performing the second determination of abnormality, the control device (60) acquires a holding position of the component (100) by the holding member by the image processing, inputs a size of the component (100), and controls the moving device so that the component (100) held by the holding member moves to the detection position based on the obtained holding position and the input size of the component (100).

## Patentansprüche

1. Eine Bauteilbestückungsmaschine (10), die dazu eingerichtet ist, ein Bauteil (100) zu halten und das Bauteil (100) auf einer Leiterplatte zu bestücken, wobei die Maschine umfasst:
einen Kopf (40) mit einem Halteelement, das dazu eingerichtet ist, das Bauteil (100) von einer Oberseite her zu halten;
eine Bewegungsvorrichtung, die dazu eingerichtet ist, den Kopf (40) zu bewegen;
eine Bildaufnahmevorrichtung, die dazu eingerichtet ist, das vom Halteelement gehaltene Bauteil (100) aus einer zu einer Unterseite senkrechten Richtung aufzunehmen; und
eine Steuervorrichtung (60), die dazu eingerichtet ist, den Kopf (40) und die Bewegungsvorrichtung so zu steuern, dass das vom Halteelement gehaltene Bauteil (100) nach Durchführung einer Bildverarbeitung zur Verarbeitung eines durch die Bildaufnahmevorrichtung aufgenommenen Bildes des Bauteils (100) auf der Leiterplatte bestückt wird, wobei
wenn ein Bauteil (100), das einen Hauptkörper (101) und mehrere seitlich von einer Seitenfläche des Hauptkörpers (101) vorstehende Anschlüsse (102) aufweist, bestückt wird, die Steuervorrichtung (60) jeweilige Längen der aus dem aufgenommenen Bild extrahierten Abbilder der
mehreren Anschlüsse (102) misst und eine erste Abnormalitätsbestimmung durch, bei der ein Fall als Abnormalität festgestellt wird, wo mindestens eine der gemessenen Längen der Abbilder der Anschlüsse (102) nicht innerhalb eines zulässigen Bereichs liegt,
wobei die Bauteilbestückungsmaschine (10) ferner umfasst:
einen optischen Sensor (50) mit einem Lichtaussendeteil (53) und einem Lichtempfangsteil (54), die einander mit einem vorbestimmten Abstand gegenüberliegend angeordnet sind, wobei
die Steuervorrichtung (60) dazu eingerichtet ist, die Bewegungsvorrichtung so zu steuern, dass sich das vom Halteelement gehaltene Bauteil (100) zu einer Detektionsposition bewegt, an der Licht vom Lichtaussendeteil (53) auf Spitzenendbereiche der mehreren Anschlüsse (102) mit einer optischen Achse, die parallel zur Anordnungsrichtung der Anschlüsse (102) verläuft, projiziert wird, eine Dicke der mehreren Anschlüsse (102) in einer Seitenansicht misst, basierend auf einem Zustand, in dem das Licht vom Lichtempfangsteil (54) empfangen wird, und eine zweite Fehlererkennung durchführt, bei der ein Fall als Abnormalität festgestellt wird, wo die gemessene Dicke nicht innerhalb eines zulässigen Bereichs liegt,, wobei
die Steuervorrichtung (60) dazu eingerichtet ist, die zweite Abnormalitätsbestimmung in einem Fall durchzuführen, wo bei der ersten Abnormalitätsbestimmung eine Abnormalität nicht festgestellt wurde.

2. Die Bauteilbestückungsmaschine (10) nach Anspruch 1, wobei
bei Durchführung der zweiten Fehlererkennung die Steuervorrichtung (60) eine Halteposition des Bauteils (100) durch das Halteelement mittels der Bildverarbeitung ermittelt, eine Größe des Bauteils (100) eingibt und die Bewegungsvorrichtung so steuert, dass sich das vom Halteelement gehaltene Bauteil (100) basierend auf der ermittelten Halteposition und der eingegebenen Größe des Bauteils (100) zur Detektionsposition bewegt.

## Revendications

1. Machine de montage de composant (10) qui est configurée pour maintenir un composant (100) et pour monter le composant (100) sur une carte, la machine comprenant :
une tête (40) comportant un élément de maintien configuré pour maintenir le composant (100) depuis un côté de surface supérieure ;
un dispositif de déplacement configuré pour déplacer la tête (40) ;
un dispositif imageur configuré pour imager le composant (100) qui est maintenu par l'élément de maintien depuis une direction perpendiculaire à une surface de fond ; et
un dispositif de commande (60) configuré pour commander la tête (40) et le dispositif de déplacement de telle sorte que le composant (100) qui est maintenu par l'élément de maintien soit monté sur la carte après la réalisation d'un traitement d'image pour traiter une image capturée du composant (100) qui est imagé par le dispositif imageur,
dans laquelle :
lors du montage d'un composant (100) qui comporte un corps principal (101) et de multiples broches (102) qui font saillie latéralement depuis une surface latérale du corps principal (101), le dispositif de commande (60) mesure chacune de longueurs d'images des multiples broches (102) qui sont extraites à partir de l'image capturée et réalise une première détermination d'anomalie selon laquelle le composant est déterminé comme étant anormal dans le cas où au moins l'une des longueurs mesurées des images des broches (102) n'est pas à l'intérieur d'une plage admissible,
dans laquelle la machine de montage de composant (10) comprend en outre :
un capteur optique (50) comportant une section de projection de lumière (53) et une section de réception de lumière (54) qui sont disposées de manière à se faire face l'une l'autre, un espace prédéterminé les séparant,
dans laquelle :
le dispositif de commande (60) est configuré pour commander le dispositif de déplacement de telle sorte que le composant (100) qui est maintenu par l'élément de maintien soit déplacé jusqu'à une position de détection au niveau de laquelle de la lumière est projetée depuis la section de projection de lumière (53) en direction de parties d'extrémité de pointe des multiples broches (102) selon un axe optique qui est parallèle à une direction d'agencement des multiples broches (102), il mesure une épaisseur des multiples broches (102) selon une vue de côté sur la base d'un état dans lequel la lumière est reçue par la section de réception de lumière (54) et il réalise une seconde détermination d'anomalie selon laquelle le composant est déterminé comme étant anormal dans le cas où l'épaisseur mesurée n'est pas à l'intérieur d'une plage admissible, et
dans laquelle :
le dispositif de commande (60) est configuré pour réaliser la seconde détermination d'anomalie dans le cas où le composant n'est pas déterminé comme étant anormal lors de la première détermination d'anomalie.

2. Machine de montage de composant (10) selon la revendication 1, dans laquelle, lors de la réalisation de la seconde détermination d'anomalie, le dispositif de commande (60) acquiert une position de maintien du composant (100) par l'élément de maintien au moyen du traitement d'image, il entre une taille du composant (100) et il commande le dispositif de déplacement de telle sorte que le composant (100) qui est maintenu par l'élément de maintien soit déplacé jusqu'à la position de détection sur la base de la position de maintien obtenue et de la taille d'entrée du composant (100).
